# DEMANDE DE BREVET EUROPEEN

(11) **EP 0 604 284 A1**
(43) Date de publication de la demande: **29.06.1994**
(21) Numéro de dépôt: 93403075.0
(22) Date de dépôt: 17.12.1993
(51) Int. Cl.: H05K 7/14

(54) **Ensemble électronique fait de deux cartes réunies par des moyens d'assemblage, et matériel électronique comportant au moins un tel ensemble**

(30) Priorité: 24.12.1992 FR 9215710
(71) Demandeur: THOMSON-CSF, 75008 Paris (FR)
(72) Inventeur: Furlan, Eddy, F-92402 Courbevoie Cedex (FR)
(74) Mandataire: Courtellemont, Alain

(57) **Abrégé**

L'invention concerne les ensembles électroniques faits de deux cartes (3, 4) du type circuits imprimés, accouplées électriquement (5) et mécaniquement (6), avec une seule fiche (7) pour leur branchement.

Pour faciliter la mise en place de ces ensembles entre deux paires de rainures (R1-R2, R'1-R2'), les moyens d'assemblage (5) des deux cartes comportent des éléments de réglage (51 - 54) pour régler la distance entre les deux cartes à deux valeurs distinctes : l'une pour l'introduction dans les rainures et l'autre pour un effet de blocage entre les rainures. A cet effet peuvent être utilisées des barres traversées par une vis (51-54) qui permet par vissage d'amener deux tronçons externes (52a, 52c) de la barre à chevaucher un tronçon interne (52b) de la barre ; le vissage est effectué après que l'ensemble électronique ait été introduit dans les rainures afin d'occasionner le blocage des cartes contre les flancs des rainures.

Application aux ensembles électroniques faits de deux cartes.

## Description

La présente invention concerne les ensembles électroniques faits de deux cartes du type circuits imprimés, réunies par des moyens d'assemblage et des conducteurs électriques et comportant une fiche à l'arrière d'une seule des deux cartes, les deux cartes étant prévues pour être positionnées simultanément entre des rainures d'un support et pour que, au terme de l'introduction, la fiche pénètre dans une fiche correspondante solidaire du support. L'invention concerne également les matériels électroniques munis d'au moins un tel ensemble.

L'introduction d'une carte simple entre des rainures requiert déjà une certaine attention et les difficultés d'introduction sont nettement plus grandes avec un ensemble électronique fait de deux cartes surtout lorsque ces deux cartes présentent chacune une face dissipative destinée à l'évacuation de calories produites lors du fonctionnement de la carte ; en effet il est alors nécessaire que les faces dissipatives des deux cartes soient convenablement appuyées sur les parois des rainures afin de favoriser la dissipation de calories par conduction. Dans les ensembles connus les deux cartes rentrent avec frottement dur dans leurs rainures respectives et l'opération s'avère difficile.

Le but de l'invention est d'éviter ou pour le moins de réduire cet inconvénient.

Ceci est obtenu en concevant les moyens d'assemblage de telle sorte qu'ils permettent de régler l'écartement entre les deux cartes selon deux valeurs distinctes : une valeur pour laquelle les deux cartes coulissent quasiment sans frottement dans leurs rainures respectives et une valeur pour laquelle chacune des cartes a l'une de ses faces fortement appuyée contre une paroi de chacune des deux rainures entre lesquelles elle se trouve ; avec les cartes comportant une face dissipative c'est évidemment cette face qui est appuyée contre les parois de rainures.

Selon l'invention il est proposé un ensemble électronique comportant une première et une seconde carte ayant chacune un bord avant, un bord arrière et deux bords latéraux, des conducteurs souples entre les deux cartes, une fiche à l'arrière de la première carte et des moyens d'assemblage comportant une plaque, pour assembler les deux cartes parallèlement l'une à l'autre et perpendiculairement à la plaque, les deux cartes étant destinées à être introduites entre deux paires de rainures parallèles, de façon à être placées entre ces deux paires de rainures parallèles avec leurs bords latéraux à l'intérieur des rainures, caractérisé en ce que les moyens d'assemblage comportent des éléments de réglage pour régler la distance entre les deux cartes à deux valeurs distinctes, l'une lorsque les cartes sont introduites dans les rainures et l'autre pour un effet de blocage des cartes entre les paires de rainures.

Selon l'invention il est également proposé un matériel électronique comportant au moins un ensemble tel que décrit au paragraphe précédent.

La présente invention sera mieux comprise et d'autres caractéristiques apparaîtront à l'aide de la description ci-après et des figures s'y rapportant qui représentent :
- la figure 1, une vue en perspective d'un ensemble électronique selon l'invention,
- les figures 2 à 5 des vues en coupe de l'ensemble selon la figure 1.

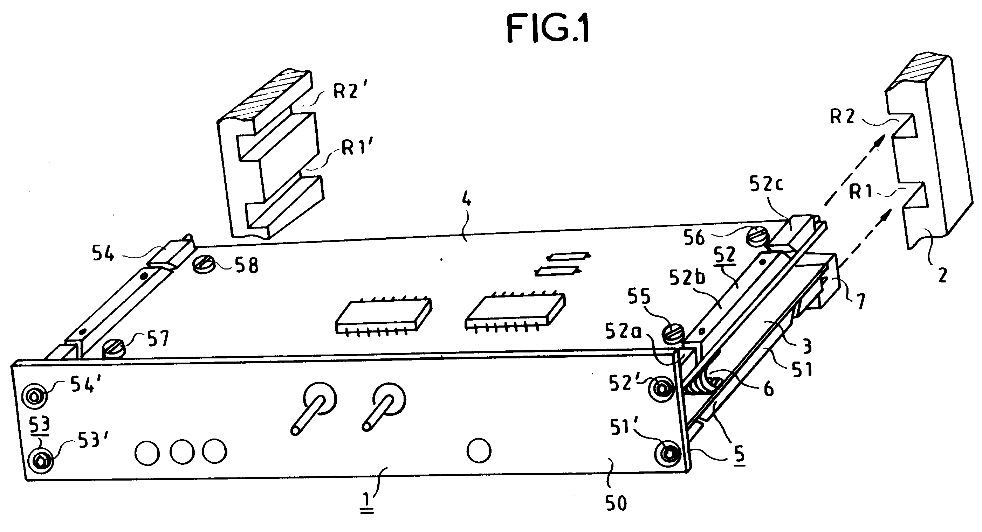

La figure 1 montre un ensemble électronique 1 constitué par un tiroir ; ce tiroir est un élément d'un matériel électronique qui comporte également un châssis 2 avec des rainures R1, R1', R2, R2' destinées à permettre l'insertion du tiroir dans le châssis. Sur la figure 1 le tiroir apparaît dans sa totalité alors que, pour ce qui est du reste du matériel, seule la partie du châssis au voisinage des rainures a été dessinée.

L'ensemble électronique 1 comporte deux cartes, 3, 4, c'est-à-dire des circuits imprimés avec leurs composants, des moyens d'assemblage 5 pour réunir mécaniquement les deux cartes, des conducteurs souples réunis en un ruban flexible 6 pour assurer les liaisons électriques entre les deux cartes et une fiche électrique mâle 7 disposée à l'arrière de la carte 3 pour permettre de relier électriquement l'ensemble 1 au reste du matériel électronique dont il fait partie. Les deux cartes sont de même dimensions et disposées côte à côte avec leurs grandes faces parallèles.

Les moyens d'assemblage 5 comportent une sorte de plaque frontale, 50, qui constitue la face avant du tiroir, quatre éléments de réglage dont seuls trois 51, 52, 54 apparaissent nettement sur la figure 1, et quatre éléments écarteurs 55 à 58.

Les éléments de réglage sont formés par une grande barre de section rectangulaire fendue en biais au voisinage de chacune de ses deux extrémités pour former trois tronçons tels que 52a, 52b et 52c. Les quatre barres sont fixées par leur tronçon interne, tel que 52b, sur les grandes faces du parallélépipède que constituent les deux cartes, au voisinage des petits côtés de ces grandes faces. Chaque barre comporte une vis, 51' à 54', qui traverse librement les trois tronçons sauf au voisinage de sa pointe où elle passe par un trou taraudé à un pas correspondant à son propre pas ; la tête de ces vis est une tête creuse hexagonale, visible sur la figure 1 et accessible par des trous percés dans la plaque 50 ; ainsi en vissant ou en dévissant une vis telle de 52' il est possible, du fait des fentes en biais qui séparent les tronçons d'une même barre, de faire que les tronçons externes, tels que 52a, 52c chevauchent plus ou moins le tronçon interne et ainsi-s'écartent plus ou moins, et simultanément, de leurs cartes respectives.

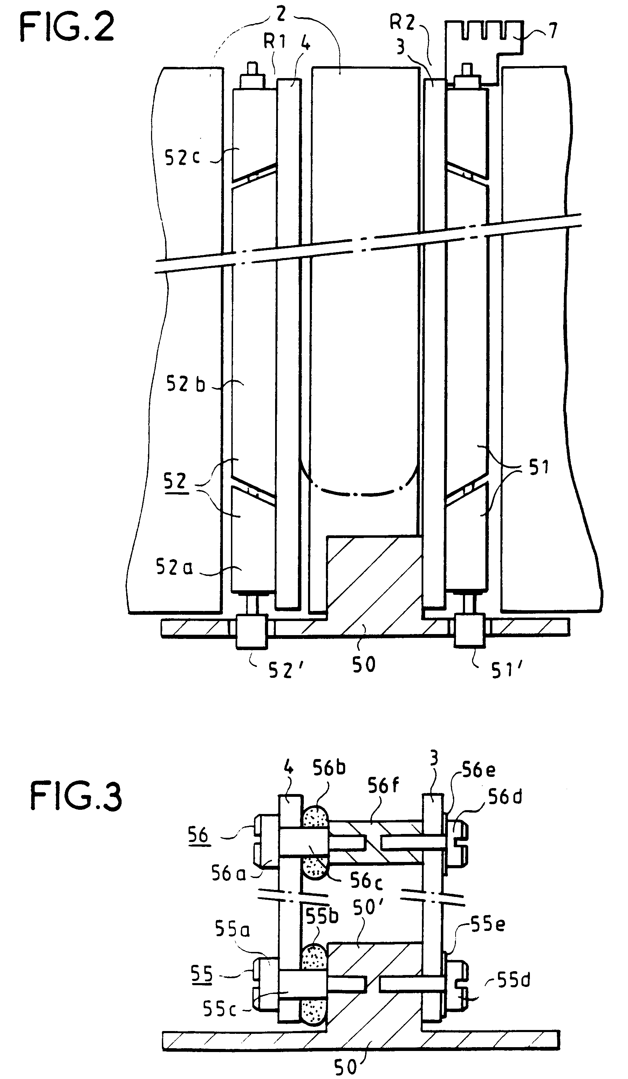

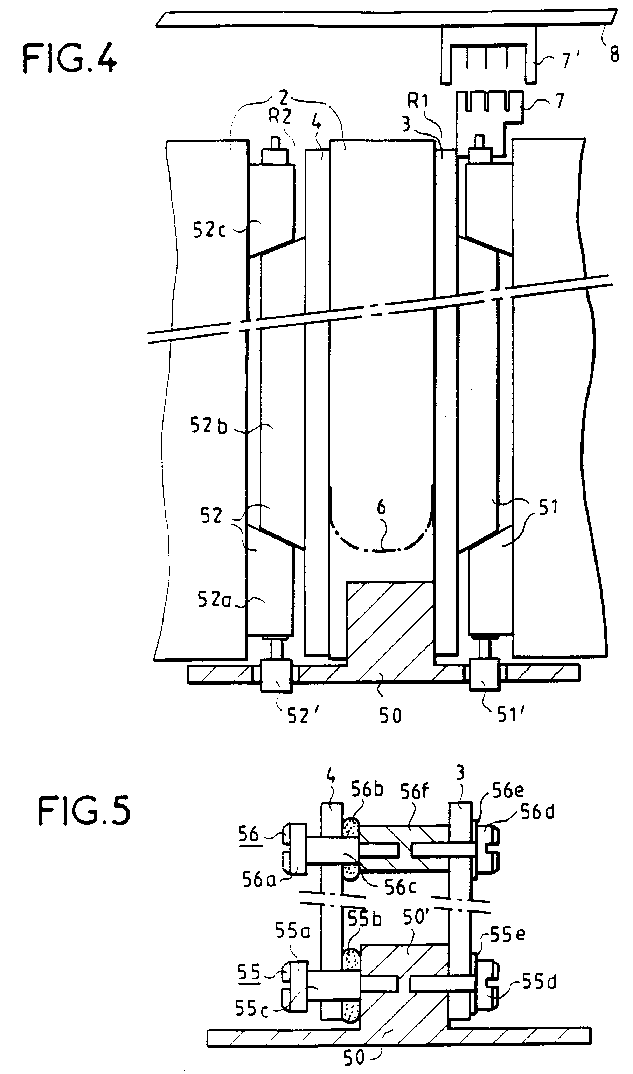

Les éléments écarteurs 55 à 58 seront décrits à l'aide des figures 3 et 5.

Les figures 2 et 4 sont des vues obtenues après une découpe par un plan disposé à une distance du fond des rainures R1 et R2 égale à environ la moitié de la profondeur de ces rainures ; la découpe est effectuée dans le châssis 2 et dans la plaque 50 de l'ensemble électronique 1 et montre les deux cartes 3, 4 alors qu'elles sont totalement introduites dans les rainures R1, R2. Sur la figure 4 a été représentée une carte 8, dite carte mère, solidaire du châssis 2 ; cette carte mère comporte une fiche femelle 7' qui correspond à la fiche mâle 7 de l'ensemble électronique 1. Il est à noter que, compte tenu de ce que dans les figures 2 et 4 les deux cartes sont totalement introduites dans les rainures, la fiche 7 est alors totalement introduite dans la fiche 7' mais il a été jugé préférable de représenter cette fiche 7' un peu en retrait sur la figure 4 afin que sa constitution apparaisse plus nettement. Dans le cas de l'exemple décrit la fiche 7' est équipée de contacts mobiles sur environ ± 0,3 mm autour d'une position de repos et selon une direction qui est perpendiculaire à la direction de pénétration des fiches et qui est située dans le plan des figures 2 et 4 ; des connecteurs où la fiche femelle, tout en étant solidaire d'un support fixe, a ses contacts qui peuvent suivre des déplacements latéraux de faible amplitude de la fiche mâle, sont disponibles dans le commerce, par exemple sous l'appellation "connecteurs de type SIHD" ; I'utilité de tels connecteurs apparaîtra dans ce qui suit.

Sur la figure 2 les barres 51 et 52 sont représentées dans la position qui leur est donnée pour que, avec les cartes 3 et 4, elles puissent facilement pénétrer dans les rainures R1 et R2 ; cette position est celle où les vis 51' et 52' ne sont pas serrées et où, de ce fait, les tronçons externes des barres ne chevauchent pas le tronçon interne.

Par contre dès que l'introduction des cartes est effectuée les quatre vis telles que 51' et 52' peuvent être serrées afin d'occasionner, dans chacune des quatre barres, le chevauchement du tronçon interne, tel que 52b, par les deux tronçons externes tels que 52a et 52c ; la figure 4 correspond à la figure 2 après serrage des vis et donc chevauchement des tronçons de chacune des quatre barres.

Comme il apparaît sur la figure 4 ce chevauchement a pour effet d'amener les tronçons externes, tels que 52a, 52c, en contact avec une des deux parois verticales de la rainure, telle que R2, et, en repoussant dans l'autre sens le tronçon interne, d'amener la carte, telle que 4, en contact avec l'autre paroi verticale de la rainure. Il est à noter, d'une part, que dans ces mouvements qui amènent les cartes en contact avec les parois des fentes la fiche mâle 7, solidaire de la carte 3 et qui était déjà introduite dans la fiche femelle 7', se déplace légèrement ; ceci explique le choix qui a été fait, comme indiqué plus avant, d'un connecteur 7-7' à contacts mobiles. Il est à noter d'autre part que, dans l'exemple décrit, chacune des deux cartes comporte un drain thermique c'est-à-dire une plaque métallique qui facilite l'évacuation, vers le milieu extérieur, des calories produites dans la carte, la carte présentant ainsi une face dite face dissipative ; afin d'assurer une évacuation optimale des calories produites dans les cartes, les faces dissipatives des cartes 3 et 4 sont tournées l'une vers l'autre de manière qu'elles viennent en contact sur deux de leurs côtés avec la paroi des rainures R1 et R2 et qu'ainsi le châssis 2 dans lequel sont tracées les rainures serve de radiateur pour la dissipation des calories provenant des cartes. Dans le cas où la fixation des barres 51, 52 sur les cartes 3 et 4 aurait été effectuée, non pas de part et d'autre de ces cartes comme dans l'exemple décrit, mais entre les cartes, les faces dissipatives auraient été tournées vers l'extérieur du parallélogramme formé par les deux cartes de manière à venir chacune en contact avec les parois de rainures ; ceci revient à dire que, lorsque les éléments de réglage pour régler l'écartement entre les deux cartes sont fixés soit sur les faces en regard des cartes soit sur les faces opposées, les faces dissipatives de ces cartes seront respectivement les faces opposées ou les faces en regard.

Dans ce qui précède les éléments écarteurs 55 à 58 destinés à maintenir les deux cartes 3, 4 sensiblement dans des plans parallèles et à autoriser la modification de la distance entre ces deux cartes, n'ont été que mentionnés à l'occasion de la description de la figure 1 ; ils vont être décrits plus en détail à l'aide des figures 3 et 5.

Les figures 3 et 5 sont des vues en coupe par un plan perpendiculaire aux grandes faces des cartes et passant par les éléments écarteurs 55, 56 ; des figures identiques auraient été obtenues en faisant passer le plan de coupe par les éléments écarteurs 57, 58. La figure 3 correspond au cas déjà traité à l'aide de la figure 2, c'est-à-dire au cas où les cartes 3, 4 de l'élément électronique 1 sont écartées au maximum et où les tronçons des barres 51 à 54 ne se chevauchent pas. La figure 5 correspond, quant à elle, au cas déjà traité à l'aide de la figure 4 où l'élément électronique 1 est coincé dans les rainures grâce au chevauchement des tronçons de ses barres.

Comme le montrent les figures 3 et 5 chaque élément écarteur comporte deux vis telles que 55a, 55d et 56a, 56d ; les deux vis d'un même élément écarteur sont dans le prolongement l'une de l'autre et ont leurs pointes en regard. Les vis 55a, 56a et 55d, 56d traversent respectivement les cartes 4 et 3 pour se visser dans une entretoise telle que 50' pour 55a et 55d et que 56f pour 56a et 56d ; l'entretoise 56f est une pièce cylindrique autonome tandis que l'entretoise 50' est une excroissance à l'arrière de la plaque 50. Avant de traverser la carte 3 et de se visser respectivement dans les entretoises 50', 56f les vis 55d, 56d traversent une rondelle 55e, 56e ; quant aux vis 55a, 56a, avant de se visser respectivement dans les entretoises 50', 56f, elles traversent une colonnette creuse, 55c, 56c, qui elle-même traverse la carte 4 puis un anneau en caoutchouc, 55b, 56b.

Le fonctionnement des éléments écarteurs de l'ensemble électronique 1 se comprend aisément grâce aux figures 3 et 5 :
- tant que les éléments de réglage formés par les barres 51 à 54 et étudiés à l'aide des figures 1, 2 et 4, n'ont pas leurs tronçons qui se chevauchent, les anneaux en caoutchouc, tels que 55b, 56b, d'ailleurs en légère compression, repoussent la carte 4 qui est retenue par les têtes des vis telles que 55a, 56a ; ceci est illustré par la figure 3,
- quand les éléments de réglage ont leurs tronçons qui se chevauchent et qui, en appuyant sur les parois des fentes, rapprochent les cartes 3 et 4, la carte 4, en étant repoussée en direction de la carte 3, s'écarte des têtes des vis telles que 55a, 56a et presse fortement sur les anneaux en caoutchouc tels que 55b, 56B ; ces anneaux s'aplatissent comme illustré par la figure 5.

La présente invention n'est pas limitée à l'exemple décrit et à sa variante selon laquelle, après avoir introduit les deux cartes dans les rainures, l'effet de blocage est obtenu en augmentant, par des éléments de réglage, la distance entre les deux cartes. L'invention s'applique d'une façon plus générale à toute réalisation d'un ensemble électronique fait de deux cartes et comportant des éléments de réglage pour permettre de choisir entre deux valeurs distinctes pour la distance séparant les deux cartes.

Ainsi il peut être envisagé de faire que la carte qui ne porte pas de fiche, puisse coulisser sur deux rails disposés à l'arrière de la plaque frontale, perpendiculairement au plan des cartes et si les cartes sont suffisamment rigides il peut être envisagé alors de ne pas utiliser d'éléments écarteurs, par contre l'introduction de l'ensemble électronique nécessitera de donner manuellement à la distance entre les cartes une valeur permettant cette introduction. Quant aux éléments écarteurs, ils peuvent comporter, par exemple, un cylindre creux, un ressort à boudin à l'intérieur du cylindre, un piston qui appuie sur le ressort et une ou deux butées pour limiter la course du piston ; et il est même possible d'utiliser des vérins disposés entre les deux cartes pour constituer, avec chaque vérin, à la fois un élément de réglage et un élément écarteur.

## Revendications

1. Ensemble électronique comportant une première (3) et une seconde (4) carte ayant chacune un bord avant, un bord arrière et deux bords latéraux, des conducteurs souples (6) entre les deux cartes, une fiche (7) à l'arrière de la première carte et des moyens d'assemblage (5) comportant une plaque (50), pour assembler les deux cartes parallèlement l'une à l'autre et perpendiculairement à la plaque, les deux cartes étant destinées à être introduites entre deux paires de rainures parallèles parallèles (R1-R2, R1'-R2'), de façon à être placées entre ces deux paires de rainures parallèles avec leurs bords latéraux à l'intérieur des rainures, caractérisé en ce que les moyens d'assemblage comportent des éléments de réglage (51-54) pour régler la distance entre les deux cartes à deux valeurs distinctes, l'une lorsque les cartes sont introduites dans les rainures et l'autre pour un effet de blocage des cartes entre les paires de rainures.

2. Ensemble électronique selon la revendication 1 dont les cartes (3, 4) comportent chacune une face dissipative, caractérisé en ce que les faces dissipatives des deux cartes sont en regard et en ce que la valeur pour l'introduction est supérieure à la valeur pour l'effet de blocage.

3. Ensemble selon la revendication 1, caractérisé en ce que les éléments de réglage (51-54) sont quatre barres découpées en biseau pour former chacune un tronçon interne (52b) et deux tronçons externes (52a, 52c) entourant le tronçon interne, ces barres comportant une vis (51'-54') qui traverse les tronçons et comporte une tête située à une extrémité de la barre considérée et une pointe qui se visse dans le tronçon externe (52c) de l'autre extrémité de la barre considérée et en ce que les tronçons internes (52b) des barres sont respectivement fixés au voisinage des quatre bords latéraux relatifs aux deux cartes (3, 4), avec les têtes des vis du côté des bord avant des cartes.

4. Ensemble électronique selon l'une des revendications précédentes, caractérisé en ce que les moyens d'assemblage comportent des éléments écarteurs (55-58) qui, chacun, relient mécaniquement les deux cartes (3, 4) et en ce que ces éléments écarteurs sont compressibles selon une direction perpendiculaire aux cartes qu'ils relient.

5. Matériel électronique comportant un châssis (2) avec des paires de rainures (R1-R2, R1'-R2'), caractérisé en ce qu'il comporte au moins un ensemble électronique selon l'une des revendications précédentes, les rainures du châssis étant au moins pour certaines d'entre elles, celles dans lesquelles les cartes (3, 4) sont destinées à être introduites.
